(19) Europäisches Patentamt / European Patent Office / Office européen des brevets

(11) **EP 4 369 600 A1**

(12) **EUROPEAN PATENT APPLICATION**
published in accordance with Art. 153(4) EPC

(43) Date of publication:
**15.05.2024 Bulletin 2024/20**

(51) International Patent Classification (IPC):
**H03G 3/30** (2006.01)

(21) Application number: **22837023.5**

(86) International application number:
**PCT/CN2022/104425**

(22) Date of filing: **07.07.2022**

(87) International publication number:
**WO 2023/280278 (12.01.2023 Gazette 2023/02)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **08.07.2021 CN 202110773516**

(71) Applicant: **Chipsea Technologies (Shenzhen)
Corp.
Shenzhen, Guangdong 518067 (CN)**

(72) Inventors:
• **CHEN, Min**
**Shenzhen, Guangdong 518067 (CN)**
• **CHEN, Peiteng**
**Shenzhen, Guangdong 518067 (CN)**

(74) Representative: **Petraz, Gilberto Luigi et al
GLP S.r.l.
Viale Europa Unita, 171
33100 Udine (IT)**

(54) **PROGRAMMABLE GAIN AMPLIFIER, INTEGRATED CIRCUIT, ELECTRONIC DEVICE, AND FREQUENCY CORRECTION METHOD**

(57) Embodiments of the present application provide a programmable gain amplifier, an integrated circuit, an electronic device, and a frequency correction method. The programmable gain amplifier comprises a first-stage operational transconductance amplifier, a second-stage operational transconductance amplifier, a capacitor module, a clock oscillator circuit, and a correction circuit; an input end of the second-stage operational transconductance amplifier is connected to an output end of the first-stage operational transconductance amplifier; the capacitor module is connected between the output end of the first-stage operational transconductance amplifier and the output end of the second-stage operational transconductance amplifier; the clock oscillator circuit is connected to the output end of the first-stage operational transconductance amplifier and the capacitor module, and is configured to charge/discharge the capacitor module by means of an output current of the first-stage operational transconductance amplifier to output a clock signal; the correction circuit is connected to the clock oscillator circuit and the capacitor module, and is configured to adjust the capacitance value of the capacitor module, so that the clock frequency of the clock signal is consistent with a preset clock frequency.

FIG. 1

# Description

## CROSS-REFERENCE TO RELATED APPLICATIONS

This application claims priority of Chinese Application No. 202110773516X, filed on July 8, 2021, which is incorporated herein by reference in its entirety for all purposes.

## TECHNICAL FIELD

The present disclosure relates to electronic circuit technologies, and more particularly, to a programmable gain amplifier, an integrated circuit, an electronic device, and a frequency correction method.

## BACKGROUND

A programmable gain amplifier (PGA) is an analog circuit module and may be widely applied in various devices such as a wireless communication device and a medical device. The circuit performance of the PGA often determines the overall performance of a system to which the PGA is applied.

With the rapid development of the communication technology, there is a need for higher and higher communication rates, which may put forward requirements for a greater bandwidth of the PGA. However, due to factors such as manufacturing errors and process variations, frequency characteristics of the PGA may vary greatly, thereby affecting the bandwidth of the PGA. For example, if a capacitor in the PGA has a process deviation of 20%, it may cause a great deviation in the bandwidth of the PGA and deteriorate the performance of the PGA.

## SUMMARY

In view of the above problems, embodiments of the present disclosure provide a programmable gain amplifier, an integrated circuit, an electronic device, and a frequency correction method, so as to solve the above technical problems.

The embodiments of the present application are implemented by following technical solutions.

A programmable gain amplifier is provided, including: a first-stage operational transconductance amplifier; a second-stage operational transconductance amplifier having an input terminal connected to an output terminal of the first-stage operational transconductance amplifier; a capacitor module connected between the output terminal of the first-stage operational transconductance amplifier and an output terminal of the second-stage operational transconductance amplifier; a clock oscillation circuit connected to both the output terminal of the first-stage operational transconductance amplifier and the capacitor module and configured to perform charging and discharging of the capacitor module by an output current from the first-stage operational transconductance amplifier to output a clock signal; and a correction circuit connected to both the clock oscillation circuit and the capacitor module and configured to adjust a capacitance of the capacitor module to enable a clock frequency of the clock signal to be consistent with a preset clock frequency.

An integrated circuit according to one or more embodiments of the present disclosure includes the above programmable gain amplifier.

An electronic device according to one or more embodiments of the present disclosure includes a device body and the above integrated circuit disposed within the device body.

A frequency correction method according to one or more embodiments of the present disclosure is applicable to a programmable gain amplifier. The programmable gain amplifier includes: a first-stage operational transconductance amplifier; a second-stage operational transconductance amplifier having an input terminal connected to an output terminal of the first-stage operational transconductance amplifier; and a compensation capacitor connected between the output terminal of the first-stage operational transconductance amplifier and an output terminal of the second-stage operational transconductance amplifier. The frequency correction method includes: performing charging and discharging of the compensation capacitor by an output current from the first-stage operational transconductance amplifier to output a clock signal; and adjusting a capacitance of the compensation capacitor to enable a clock frequency of the clock signal to be consistent with a preset clock frequency.

The programmable gain amplifier, the integrated circuit, the electronic device, and the frequency correction method are provided according to the embodiments of the present disclosure, where the programmable gain amplifier includes: a first-stage transconductance amplifier; a second-stage transconductance amplifier having an input terminal connected to an output terminal of the first-stage transconductance amplifier; a capacitor module connected between an input terminal of the second-stage transconductance amplifier and an output terminal of the second-stage transconductance amplifier; a clock oscillation circuit connected to both the output terminal of the first-stage transconductance amplifier and the capacitor module and configured to charge or discharge the capacitor module with an output current of the first-stage transconductance amplifier to output a clock signal; and a correction circuit connected to both the clock oscillation circuit and the capacitor module and configured to adjust a capacitance value of the capacitor module to enable a clock frequency of the clock signal to be consistent with a preset clock frequency. The programmable gain amplifier according to the embodiments of the present disclosure charges or discharges the capacitor module with the output current of the first-stage transconductance amplifier by a clock oscillation circuit to output the clock signal, and then adjusts the capacitor value of the capacitor module by the correction circuit to enable the clock frequency of the clock signal to be consistent with the preset clock frequency, so that the clock frequency of the clock oscillation circuit is stabilized at the preset clock frequency, thereby eliminating the influence on the clock frequency due to the process variation. Since the bandwidth of the programmable amplifier is related to the clock frequency of the clock oscillation circuit, it is ensured that the constant bandwidth of the programmable amplifier is not affected by the process.

These or other aspects of the present disclosure will be more readily apparent from description of following embodiments.

BRIEF DESCRIPTION OF THE DRAWINGS

In order to more clearly illustrate the technical solutions in embodiments of the present disclosure, the accompanying drawings depicted in the description of the embodiments will be briefly described below. It will be apparent that the accompanying drawings in the following description are merely some embodiments of the present disclosure, and other drawings may be obtained from these drawings without creative effort by those skilled in the art.

FIG. 1 illustrates a block diagram of a programmable gain amplifier according to some embodiments of the present disclosure.
FIG. 2 illustrates a block diagram of an example of a programmable gain amplifier according to some embodiments of the present disclosure.
FIG. 3 illustrates an example circuit structure of a programmable gain amplifier according to some embodiments of the present disclosure.
FIG. 4 illustrates an example diagram of a programmable gain amplifier in a correction mode according to some embodiments of the present disclosure.
FIG. 5 illustrates an example diagram of a programmable gain amplifier in an operation mode according to some embodiments of the present disclosure.
FIG. 6 illustrates a schematic flowchart of a frequency correction method according to some embodiments of the present disclosure.
FIG. 7 illustrates an example diagram of a programmable gain amplifier.
FIG. 8 is a block diagram of a step S310 in FIG. 6.
FIG. 9 is a block diagram of a step S320 in FIG. 6.

DETAILED DESCRIPTION

Some embodiments of the present disclosure will be described in detail below with reference to the accompanying drawings, in which the same or similar reference numerals indicate the same or similar elements or elements having the same or similar functions. The embodiments are described for illustrative purposes only and shall not to be construed as limiting the present disclosure.

In order that technical solutions of the present disclosure may be better understood by those skilled in the art, technical solutions in embodiments of the present disclosure will be clearly and completely described below in conjunction with drawings in the embodiments of the present disclosure. Obviously, the described embodiments are only a part of embodiments of the present application, rather than all the embodiments. Based on the embodiments in the present disclosure, all other embodiments obtained by those skilled in the art without creative work fall within the protection scope of the present disclosure.

A programmable gain amplifier (PGA) is an analog circuit module and may be widely applied in various devices such as a wireless communication device and a medical device. The circuit performance of the PGA often determines the overall performance of a system to which the PGA is applied.

With the rapid development of the communication technology, there is a need for higher and higher communication rates, which may put forward requirements for a greater bandwidth of the PGA. A gain bandwidth $GB$ of a conventional PGA satisfies: $GB \propto gm/Cc$, where $gm$ represents a transconductance of an input stage, and $Cc$ represents a Miller compensation capacitance. However, due to factors such as manufacturing errors and process variations, frequency characteristics of the PGA may vary greatly, thereby affecting the bandwidth of the conventional PGA. For example, if a capacitor in the PGA has a process deviation of 20%, it may cause a great deviation in the bandwidth of the PGA and deteriorate the performance of the PGA.

In view of the above, a programmable gain amplifier, an integrated circuit, an electronic device, and a frequency correction method according to the embodiments of the present disclosure are proposed by the inventors, where the programmable gain amplifier includes: a first-stage operational transconductance amplifier; a second-stage operational transconductance amplifier having an input terminal connected to an output terminal of the first-stage operational transconductance amplifier; a capacitor module connected between an input terminal of the second-stage operational transconductance amplifier and an output terminal of the second-stage operational transconductance amplifier; a clock oscillation circuit connected to both the output terminal of the first-stage operational transconductance amplifier and the capacitor module and configured to perform charging and discharging of the capacitor module by an output current from the first-stage operational transconductance amplifier to output a clock signal; and a correction circuit connected to both the clock oscillation circuit and the capacitor module and configured to adjust a capacitance of the capacitor module to enable a clock frequency of the clock signal to be consistent with a preset clock frequency. The programmable gain amplifier according to the embodiments of the present disclosure uses a clock oscillation circuit to perform charging and discharging of the capacitor module by the output current from the first-stage operational transconductance amplifier to output the clock signal, and then adjusts the capacitor value of the capacitor module by the correction circuit to enable the clock frequency of the clock signal to be consistent with the preset clock frequency, so that the clock frequency of the clock oscillation circuit is stabilized at the preset clock frequency, thereby eliminating the influence on the clock frequency due to the process variation. Since the bandwidth of the programmable gain amplifier is related to the clock frequency of the clock oscillation circuit, it is ensured that the constant bandwidth of the programmable gain amplifier is not affected by the process.

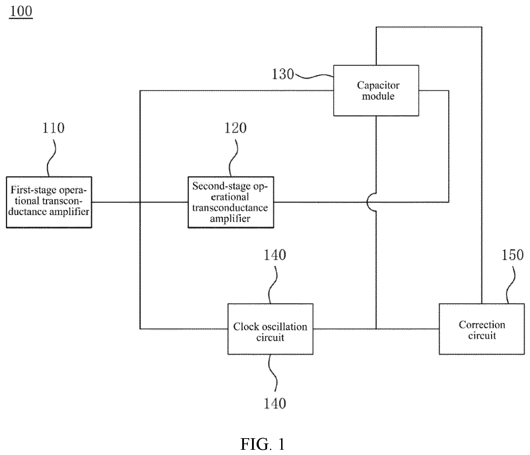

As shown in FIG. 1, an embodiment of the present disclosure provides a programmable gain amplifier 100, including: a first-stage operational transconductance amplifier 110, a second-stage operational transconductance amplifier 120, a capacitor module 130, a clock oscillation circuit 140, and a correction circuit 150. An input terminal of the second-stage operational transconductance amplifier 120 is connected to an output terminal of the first-stage operational transconductance amplifier 110. The capacitor module 130 is connected between the output terminal of the first-stage operational transconductance amplifier 110 and an output terminal of the second-stage operational transconductance amplifier 120. The clock oscillation circuit 140 is connected to the output terminal of the first-stage operational transconductance amplifier 110 and the capacitor module 130 and configured to perform charging and discharging of the capacitor module 130 by an output current from the first-stage operational transconductance amplifier 110 to output a clock signal. The correction circuit 150 is connected to the clock oscillation circuit 140 and the capacitor module 130 and configured to adjust a capacitance of the capacitor module 130 to enable a clock frequency of the clock signal to be consistent with a preset clock frequency.

In the present embodiment, the first-stage operational transconductance amplifier 110 and the second-stage operational transconductance amplifier 120 may constitute two stage operational transconductance amplifiers, where the second-stage operational transconductance amplifier 120 is configured to amplify an output signal of the first-stage operational transconductance amplifier 110. It should be noted that the first-stage operational transconductance amplifier 110 and the second-stage operational transconductance amplifier 120 may also be constituent elements of multi-stage operational transconductance amplifiers, that is, the programmable gain amplifier 100 may include multi-stage operational transconductance amplifiers.

The capacitor module 130 is connected between the output terminal of the first-stage operational transconductance amplifier 110 and the output terminal of the second-stage operational transconductance amplifier 120 to form a feed-forward path that can compensate for the first-stage operational transconductance amplifier 110 and the second-stage operational transconductance amplifier 120. In some implementations, the capacitor module 130 may include a plurality of selectable capacitors, and a capacitance of the capacitor module 130 may be adjusted by reasonably configuring the number of strobe capacitors within the capacitor module 130.

The clock oscillation circuit 140 and the capacitor module 130 are also connected to the output terminal of the first-stage operational transconductance amplifier 110, that is, there is a connection relationship between the clock oscillation circuit 140 and the capacitor module 130. In the present embodiment, the clock oscillation circuit 140 performs charging and discharging of the capacitor module 130 by an output current from the first-stage operational transconductance amplifier 110 to output a clock signal. Specifically, when the output current of the first-stage operational transconductance amplifier 110 is configured to charge the capacitor module 130 to enable the capacitor module 130 to be in a charging state, a voltage across the capacitor module 130 is gradually increased, that is, an input voltage of the clock oscillation circuit 140 is increased; and when the capacitor module 130 is in a discharging state, the voltage across the capacitor module 130 is gradually decreased, that is, the input voltage of the clock oscillation circuit 140 is decreased. The clock oscillation circuit 140 is configured to output a clock signal according to the change of the input voltage. It should be noted that the gain bandwidth of the programmable gain amplifier 100 is related to the clock frequency of the clock signal output from the clock oscillation circuit 140, so that, when the clock frequency of the clock signal is constant, the gain bandwidth of the programmable gain amplifier 100 is also constant.

The correction circuit 150 may receive the clock signal output from the clock oscillation circuit 140 and correct the clock frequency of the clock signal to be consistent with a preset clock frequency. Specifically, since the clock frequency of the clock signal is related to a charging/discharging speed of the capacitor module 130, the correction circuit 150 may change the charging/discharging speed of the capacitor module 130 by adjusting the capacitance of the capacitor module 130, thereby changing the clock frequency of the clock signal output from the clock oscillation circuit 140.

Specifically, the correction circuit 150 can adjust the clock frequency of the clock signal to be consistent with the preset clock frequency by adjusting the capacitance of the capacitor module 130, so that the clock frequency of the clock signal is stabilized at the preset clock frequency, thereby eliminating the influence on the clock frequency of the clock signal due to the capacitor process variation and ensuring that the programmable gain amplifier maintains a constant bandwidth without being affected by the capacitor process.

It can be seen from the above that the programmable gain amplifier 100 of the programmable gain amplifier 100 according to the embodiment of the present disclosure uses the clock oscillation circuit 140 to perform charging and discharging of the capacitor module 130 by the output current from the first-stage operational transconductance amplifier 110 to output a clock signal, and then adjusts the capacitor value of the capacitor module 130 by the correction circuit 150 to enable the clock frequency of the clock signal to be consistent with the preset clock frequency, so that the clock frequency of the clock oscillation circuit 140 is stabilized at the preset clock frequency, thereby eliminating the influence of the clock frequency due to the process variation. Since the bandwidth of the programmable gain amplifier is related to the clock frequency of the clock oscillation circuit 140, it is ensured that the constant bandwidth of the programmable gain amplifier is not affected by the process.

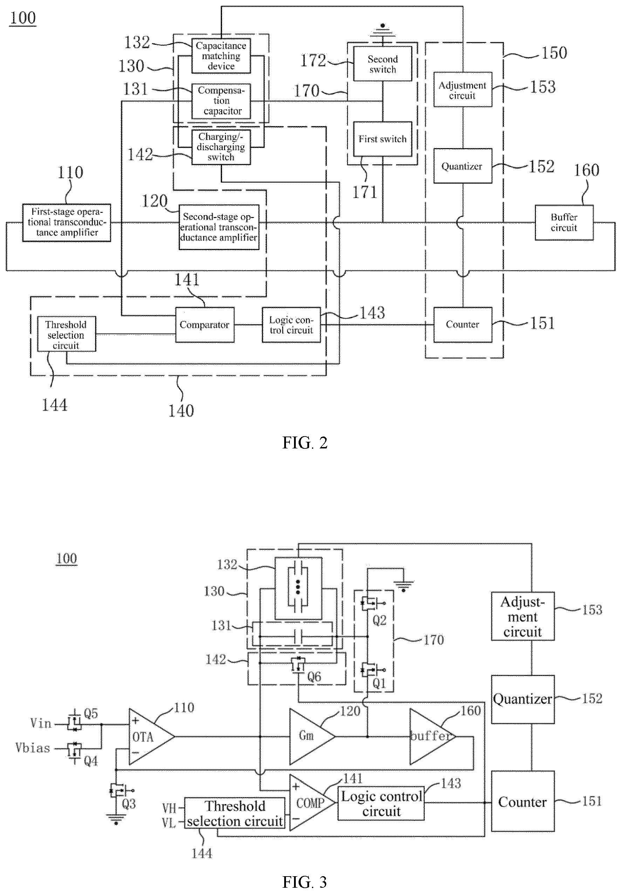

FIG. 2 illustrates a block diagram of an example of a programmable gain amplifier according to some embodiments of the present disclosure. The programmable gain amplifier 100 may further include a buffer circuit 160 connected to the output terminal of the second-stage operational transconductance amplifier 120, where an output terminal of the buffer circuit 160 may further be connected to the input terminal of the first-stage operational transconductance amplifier 110. The buffer circuit 160 may play a role of matching output impedance and can reduce signal distortion.

As one implementation, the capacitor module 130 includes a compensation capacitor 131 and a capacitance matching device 132. The compensation capacitor 131 is connected between the output terminal of the first-stage operational transconductance amplifier 110 and the output terminal of the second-stage operational transconductance amplifier 120. Specifically, one terminal of the compensation capacitor 131 is connected to the output terminal of the first-stage operational transconductance amplifier 110 and another terminal of the compensation capacitor 131 is connected to the output terminal of the second-stage operational transconductance amplifier 120. The capacitance matching device 132 is connected in parallel with the compensation capacitor 131. In the present embodiment, the compensation capacitor 131 is a Miller compensation capacitor. The capacitance matching device 132 may include a plurality of capacitors, and the capacitance of the capacitance matching device 132 may be adjusted by appropriately configuring the plurality of capacitors in the capacitance matching device 132. Since the capacitance matching device 132 and the compensation capacitor 131 are connected in parallel to each other to form the capacitor module 130, when the capacitance of the capacitance matching device 132 is adjusted, the capacitance of the capacitor module 130 is changed correspondingly, which is equivalent to adjusting the capacitance of the compensation capacitor 131. That is, the capacitance of the capacitor module 130 is adjusted by adjusting the capacitance of the capacitance matching device 132, which is equivalent to adjusting the capacitance of the compensation capacitor 131 and also equivalent to adjusting the capacitance of the capacitor module 130. Parameters, such as the charging/discharging speed and the charging/discharging time, of the capacitor module 130 can be affected by adjusting the capacitance of the capacitor module 130.

As one implementation, the clock oscillation circuit 140 includes a comparator 141, a charging/discharging switch 142, and a logic control circuit 143. The comparator 141 is connected to the capacitor module 130 and configured to compare a voltage across the capacitor module 130 with a preset threshold voltage to output a comparison signal. The charging/discharging switch 142 is connected in parallel with the capacitor module 130. The logic control circuit 143 is connected to both the comparator 141 and the charging/discharging switch 142, and configured to control the charging/discharging switch 142 to be turned on or off according to the comparison signal to perform charging and discharging of the capacitor module 130 and output the clock signal.

As one implementation, the clock oscillation circuit 140 may further include a threshold selection circuit 144 connected to the comparator 141 and configured to provide one or more preset threshold voltages to the comparator 141, where the preset threshold voltages include a first threshold voltage and a second threshold voltage. The comparator 141 is configured to compare the voltage across the capacitor module 130 with the first threshold voltage or the second threshold voltage to output respective one of comparison signals. The logic control circuit 143 is configured to output a first control signal for controlling the charging/discharging switch 142 to be turned on to perform discharging of the capacitor module 130 when the voltage across the capacitor module 130 is increased to the first threshold voltage, and output a second control signal for controlling the charging/discharging switch 142 to be turned off to charge the capacitor module 13 when the voltage across the capacitor module 130 is decreased to the second threshold voltage. As one implementation, the threshold selection circuit 144 may configure a threshold voltage as the second threshold voltage according to the first control signal and the threshold voltage as the first threshold voltage according to the second control signal.

As one implementation, a non-inverting input terminal of the comparator 141 is connected to the output terminal of the first-stage operational transconductance amplifier 110, that is, the non-inverting input terminal of the comparator 141 is connected to the same node as the capacitor module 130, and an inverting input terminal of the comparator 141 is connected to the threshold selection circuit 144, which may provide a threshold voltage to the comparator 141. In the present implementation, when the capacitor module 130 is charged by the output current of the first-stage operational transconductance amplifier 110 to enable the capacitor module 130 to be in a charging state, the threshold selection circuit 144 may configure the threshold voltage as the first threshold voltage, and the comparator 141 compares the voltage across the capacitance module 130 with the first threshold voltage. When the voltage across the capacitance module 130 is greater than the first threshold voltage, the comparator 141 inverts the comparison signal as a high level signal and outputs the high level signal to the logic control circuit 143.

The logic control circuit 143 may control the charging/discharging switch 142 to be turned on in accordance with the high level signal output from the comparator 141. The charging/discharging switch 142 may be, but not limited to, one or more combinations of a field effect transistor, a triode switch, and a silicon controlled switch. In the present implementation, the charging/discharging switch 142 may be an N-type Metal-Oxide-Semiconductor (N-MOS) transistor, and the logic control circuit 143 may output the first control signal to the charging/discharging switch 142 according to the high level signal output from the comparator 141, so that the charging/discharging switch 142 is turned on, and in this case, the first control signal may be a high level signal. In some implementations, the charging/discharging switch 142 may be a P-type Metal-Oxide-Semiconductor (P-MOS) transistor, and the logic control circuit 143 may also output the first control signal to the charging/discharging switch 142 according to the high level signal output from the comparator 141, so that the charging/discharging switch 142 is turned on, and in this case, the first control signal is a low level signal. As one implementation, when the charging/discharging switch 142 is turned on, the capacitor module 130 is short-circuited by the charging/discharging switch 142, so that the capacitor module 130 is transformed from the charging state to the discharging state. When the capacitor module 130 is transformed to the discharging state, the threshold selection circuit 144 may configure the threshold voltage from the first threshold voltage to the second threshold voltage according to an output result of the logic control circuit 143. In this case, the comparator 141 compares the voltage across the capacitor module 130 with the second threshold voltage.

When the capacitor module 130 is in the discharging state, the voltage across the capacitor module 130 is decreased. When the voltage across the capacitor module 130 is less than the second threshold voltage, the comparator 141 inverts the comparison signal as a low level signal and output the low level signal, and the logic control circuit 143 correspondingly outputs the second control signal to the charging/discharging switch 142 according to the low level signal output from the comparator 141, so that the charging/discharging switch 142 is turned off. In this case, the second control signal may be a low level signal. In some implementations, the charging/discharging switch 142 may be a P-MOS transistor, the logic control circuit 143 may also output the second control signal to the charging/discharging switch 142 according to the low level signal output from the comparator 141, so that the charging/discharging switch 142 is turned off. In this case, the second control signal is a high level signal. When the charging/discharging switch 143 is turned off, the capacitor module 130 is transformed from the discharging state to the charging state and the threshold selection circuit 144 configures the threshold voltage from the second threshold voltage to the first threshold voltage according to the second control signal output from the logic control circuit 143. It can be seen from the above that the logic control circuit 143 periodically outputs a high level signal and a low level signal, the periodic high and low level signals constitute a clock signal, and the clock frequency of the clock signal is related to the charging/discharging speed of the capacitor module 130.

As one implementation, the correction circuit 150 includes a counter 151, a quantizer 152, and an adjustment circuit 153. The counter 151 is connected to the logic control circuit 143 and configured to count the clock signal according to a preset reference clock signal to output a counting result. The quantizer 152 is connected to the counter 151 and configured to determine whether the clock frequency of the clock signal is consistent with the preset clock frequency according to the counting result, and output an adjustment signal if the clock frequency is inconsistent with the preset clock frequency. The adjustment circuit 153 is connected to both the quantizer 152 and the capacitor module 130 and configured to adjust the capacitance of the capacitor module 130 according to the adjustment signal, so that the clock frequency of the clock signal is consistent with the preset clock frequency. In the present embodiment, the frequency of the preset reference clock signal is greater than that of the clock signal. Alternatively, the preset reference clock signal may be a high frequency clock.

As one implementation, the counter 151 counts the clock signal with a high frequency preset reference clock signal and obtains a counting result. Specifically, a preset counting result corresponding to the preset clock frequency may be specified, and the quantizer 152 receives the counting result of the counter 151, and outputs an adjustment signal when the counting result is inconsistent with the specified preset counting result corresponding to the preset clock frequency. For example, it is specified that the preset counting result corresponding to the preset clock frequency is N1, and if the counting result N2 output from the counter 151 is inconsistent with N1, it indicates that the clock frequency of the clock signal is inconsistent with the preset clock frequency, and the quantizer 152 may output an adjustment signal. The adjustment circuit 153 adjusts the capacitance of the capacitor module 130 in accordance with the adjustment signal, thereby changing charging/discharging time of the capacitor module 130 and further the clock frequency of the clock signal. Specifically, the adjustment circuit 153 may adjust capacitors of the capacitance matching device 132 to adjust the capacitance of the capacitor module 130, until the counting result of the counter 151 is consistent with the preset counting result corresponding to the specified preset clock frequency, that is, the clock frequency of the clock signal is consistent with the preset clock frequency. By adjusting the clock frequency of the clock signal to be consistent with the preset clock frequency, the clock signal is kept stable, thereby eliminating the influence on the clock frequency of the clock signal due to the capacitor process variation and ensuring that the programmable gain amplifier 100 maintains a constant bandwidth without being affected by the capacitor process.

It should be noted that the clock frequency of the programmable gain amplifier 100 can be corrected by adjusting the clock frequency of the clock signal to be consistent with the preset clock frequency, so that the clock frequency of the programmable gain amplifier 100 is not affected by the capacitor process variation during a normal operation of the programmable gain amplifier 100. In some implementations, the programmable gain amplifier 100 may further include a mode switching circuit 170 that may switch the programmable gain amplifier 100 between a correction mode and an operation mode. Specifically, the mode switching mode may include: a first switch 171 connected between the capacitor module 130 and the output terminal of the second-stage operational transconductance amplifier 120; and a second switch 172 having one terminal grounded and another terminal connected between the capacitor module 130 and the first switch 171.

Principles of the programmable gain amplifier 100 provided by the embodiments of the present disclosure are explained in detail below.

As shown in FIG. 3, the programmable gain amplifier 100 may have a correction mode and an operation mode. In the correction mode, the clock frequency of the programmable gain amplifier 100 can be corrected to be consistent with the preset clock frequency. In the operation mode, the programmable gain amplifier 100 may amplify an input signal, and since the clock frequency of the programmable gain amplifier 100 is consistent with the preset clock frequency, the bandwidth of the programmable gain amplifier 100 is constant independent of the process.

As one implementation, the programmable gain amplifier 100 may be switched between the correction mode and the operation mode by the mode switching circuit 170. The mode switching circuit 170 may include: a first switch connected between the capacitor module and the output terminal of the second-stage operational transconductance amplifier 120; and a second switch having one terminal grounded and another terminal connected between the capacitor module 130 and the first switch, where, when the programmable gain amplifier 100 is configured in the correction mode, the first switch is turned off and the second switch is turned on, and when the programmable gain amplifier 100 is configured in the operation mode, the first switch is turned on and the second switch is turned off. The mode switching circuit 170 may further include a third switch, a fourth switch, and a fifth switch. One terminal of the third switch is grounded, and another terminal of the third switch is connected to a first input terminal of the first-stage operational transconductance amplifier 110 and the output terminal of the buffer circuit 160, for switching a connection state of a first input terminal of the first-stage operational transconductance amplifier 110 in the correction mode and the operation mode. One terminal of either of the fourth switch and the fifth switch is connected to a second input terminal of the first-stage operational transconductance amplifier 110, and another terminal of either of the fourth switch and the fifth switch receives an input signal, where the fourth switch is configured to enable the first-stage operational transconductance amplifier 110 to receive the input signal when the programmable gain amplifier 100 is configured in the correction mode, and the fifth switch is configured to enable the first-stage operational transconductance amplifier 110 to receive the input signal when the programmable gain amplifier 100 is configured in the operation mode.

An example in which the first switch is an MOS transistor Q1, the second switch is an MOS transistor Q2, the third switch is an MOS transistor Q3, the fourth switch is an MOS transistor Q4, and the fifth switch is an MOS transistor Q5 is taken. Each of the MOS transistors Q1-Q5 may be controlled by an external clock signal.

Specifically, when the MOS transistor Q1 is turned off, the MOS transistor Q2 is turned on, and the MOS transistor Q3 is turned on, the programmable gain amplifier 100 is switched to the correction mode. In the correction mode, the MOS transistor Q4 is turned on and the MOS transistor Q5 is turned off. In this case, the input terminal of the first-stage operational transconductance amplifier 110 receives a bias voltage $V_{bias}$.

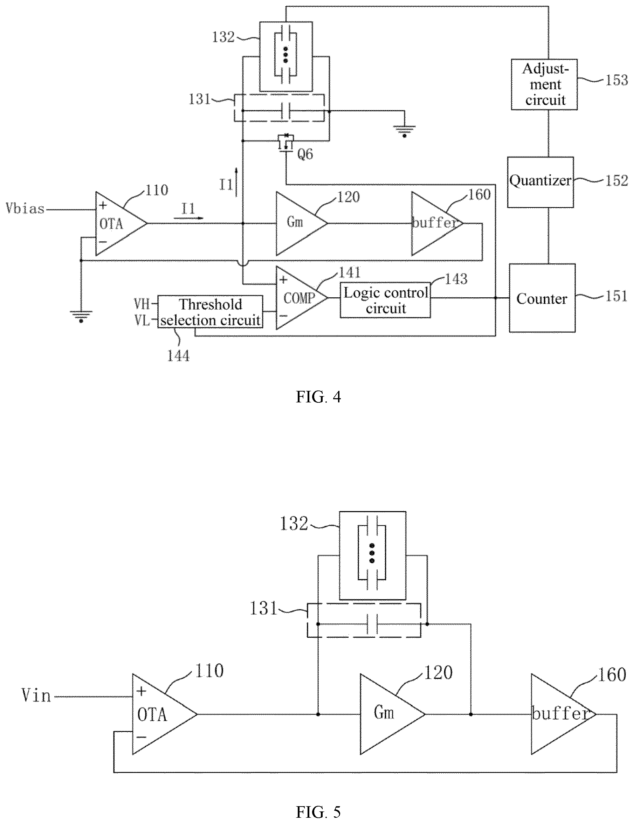

FIG. 4 illustrates an example circuit structure of a programmable gain amplifier in a correction mode according to some embodiments of the present disclosure. The first-stage operational transconductance amplifier 110 may receive the bias voltage $V_{bias}$ and output a current Ii that can be used to perform charging and discharging of the capacitor module 130. The current Ii satisfies:

$$I_1 = gm * V_{bias} \qquad (1)$$

where gm represents a transconductance of the first-stage operational transconductance amplifier 110, and $V_{bias}$ represents the bias voltage.

Specifically, one terminal of the threshold selection circuit 144 receives the first threshold voltage VH and the second threshold voltage VL, and another terminal of the threshold selection circuit 144 is connected to the inverting input terminal of the comparator 141, where the first threshold voltage VH may be higher than the second threshold voltage VL. When the current Ii initially charges the capacitor module 130, the threshold selection circuit 144 may input the first threshold voltage VH to the comparator 141. In this case, the comparator 141 compares the voltage across the capacitor module 130 with the first threshold voltage VH, and when the voltage across the capacitor module 130 is increased to be greater than the first threshold voltage, the comparator 141 inverts the comparison signal as a high level signal and outputs the high level signal to the logic control circuit 143.

Specifically, the charging/discharging switch is an MOS transistor Q6. For example, the MOS transistor Q6 is an N-MOS transistor. When the comparator 141 outputs the high level signal to the logic control circuit 143, the logic control circuit 143 outputs the high level signal to the MOS transistor Q6 to enable the MOS transistor Q6 to be turned on, and when the MOS transistor Q6 is turned on, the capacitor module 130 is transformed from the charging state to the discharging state. Specifically, the logic control circuit 143 further outputs the high level signal to the threshold selection circuit 144, and when the threshold selection circuit 144 receives the high level signal output from the logic control circuit 143, the threshold selection circuit 144 is switched to input the second threshold voltage VL to the comparator 141, so that the comparator 141 compares the voltage across the capacitor module 130 with the second threshold voltage VL in the discharging state of the capacitor module 130. When the voltage across the capacitor module 130 is decreased to be less than the second threshold voltage VL, the comparator 141 inverts the comparison signal as a low level signal and outputs the low level signal to the logic control circuit 143.

When the comparator 141 outputs the low level signal to the logic control circuit 143, the logic control circuit 143 outputs the low level signal to the MOS transistor Q6 to enable the MOS transistor Q6 to be turned off, and when the MOS transistor Q6 is turned off, the capacitor module 130 is transformed from the discharging state to the charging state. The logic control circuit 143 further outputs the low level signal to the threshold selection circuit 144, and when the threshold selection circuit 144 receives the low level signal output from the logic control circuit 143, the threshold selection circuit 144 is switched again to input the first threshold voltage VH to the comparator 141.

In a subsequent process, the logic control circuit 143 periodically outputs the high level signal and the low level signal, the periodic high and low level signals constitute a clock signal. The clock frequency of the clock signal is:

$$f = \frac{V_{bias}}{2(V_H - V_L)} * \frac{gm}{C_{total}} \qquad (2)$$

where $V_H$ represents the first threshold voltage, $V_L$ represents the second threshold voltage, and $C_{total}$ represents the capacitance of the capacitor module 130.

As one implementation, the counter 151 counts the clock signal output from the logic control circuit 143. When the counting result is inconsistent with the specified preset counting result corresponding to the preset clock frequency, it is illustrated that the clock frequency of the clock signal output from the logic control circuit 143 is inconsistent with the preset clock frequency. In this case, the quantizer 152 outputs an adjustment signal to the adjustment circuit 153. The adjustment circuit 153 adjusts the capacitance of the capacitor module 130 in accordance with the adjustment signal, thereby adjusting the capacitance of the capacitance module 130. It can be seen from the above equation (2) that the clock frequency of the clock signal is related to the capacitance of the capacitor module 130. When the adjustment circuit 153 adjusts the capacitance of the capacitor module 130 to enable the counting result of the counter 151 to be consistent with the specified preset counting result corresponding to the preset clock frequency, it is illustrated that the clock frequency of the clock signal output from the logic control circuit 143 is consistent with the preset clock frequency, that is, the clock frequency of the programmable gain amplifier 100 is corrected to be the preset clock frequency. By correcting the clock frequency of the programmable gain amplifier 100 to be the preset clock frequency, the influence on the clock frequency due to the process variation is eliminated. Since the bandwidth of the programmable gain amplifier is related to the clock frequency, the bandwidth of the programmable gain amplifier is constant and is not affected by the process.

As shown in FIG. 3, when the MOS transistor Q1 is turned on, the MOS transistor Q2 is turned off, and the MOS transistor Q3 is turned off, the programmable gain amplifier 100 is switched to the operation mode. In the operation mode, the MOS transistor Q4 is turned off and the MOS transistor Q5 is turned on. In this case, the input terminal of the first-stage operational transconductance amplifier 110 receives the input signal Vin.

FIG. 5 illustrates an example circuit structure of a programmable gain amplifier in an operation mode according to some embodiments of the present disclosure. In the operation mode, the programmable gain amplifier 100 may amplify the input signal Vin via the first-stage operational transconductance amplifier 110 and the second-stage operational transconductance amplifier 120. In this case, the gain bandwidth GB of the programmable gain amplifier 100 satisfies:

$$GB \propto \frac{V_{bias}}{V_H - V_L} * \frac{gm}{C_{total}} \qquad (3)$$

In summary, the programmable gain amplifier 100 according to some embodiments of the present disclosure can be corrected in the correction mode, so that a constant bandwidth that does not change with the process is effectively realized, thereby improving the performance of the programmable gain amplifier 100.

The programmable gain amplifier according to the embodiments of the present disclosure includes: a first-stage operational transconductance amplifier; a second-stage operational transconductance amplifier having an input terminal connected to an output terminal of the first-stage operational transconductance amplifier; a capacitor module connected between the input terminal of the second-stage operational transconductance amplifier and an output terminal of the second-stage operational transconductance amplifier; a clock oscillation circuit connected to both the output terminal of the first-stage operational transconductance amplifier and the capacitor module and configured to perform charging and discharging of the capacitor module by an output current from the first-stage operational transconductance amplifier to output a clock signal; and a correction circuit connected to both the clock oscillation circuit and the capacitor module and configured to adjust a capacitance of the capacitor module to enable a clock frequency of the clock signal to be consistent with a preset clock frequency. The programmable gain amplifier according to the embodiments of the present disclosure uses a clock oscillation circuit to perform charging and discharging of the capacitor module by the output current from the first-stage operational transconductance amplifier to output the clock signal, and then adjusts the capacitor value of the capacitor module by the correction circuit to enable the clock frequency of the clock signal to be consistent with the preset clock frequency, so that the clock frequency of the clock oscillation circuit is stabilized at the preset clock frequency, thereby eliminating the influence of the clock frequency due to the process variation. Since the bandwidth of the programmable gain amplifier is related to the clock frequency of the clock oscillation circuit, it is ensured that the constant bandwidth of the programmable gain amplifier is not affected by the process.

Some embodiments of the present disclosure further provide an integrated circuit, including the programmable gain amplifier as described above.

Some embodiments of the present disclosure provide an electronic device, including a device body and the above integrated circuit. The integrated circuit is disposed within the device body.

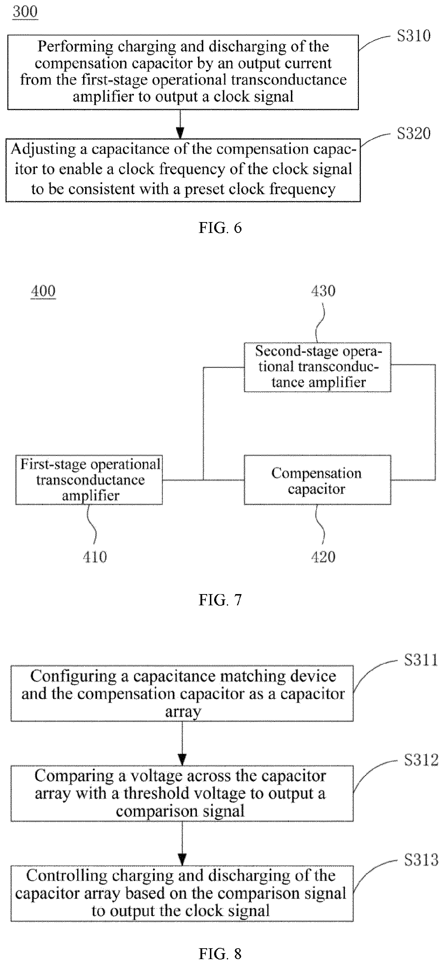

As shown in FIG. 6, some embodiments of the present disclosure further provide a frequency correction method 300, which is particularly applicable to a programmable gain amplifier. As shown in FIG. 7, a programmable gain amplifier 400 may include: a first-stage operational transconductance amplifier 410, a second-stage operational transconductance amplifier 420, and a compensation capacitor 430. An input terminal of the second-stage operational transconductance amplifier 420 is connected to an output terminal of the first-stage operational transconductance amplifier 410, and a compensation capacitor 430 is connected between the output terminal of the first-stage operational transconductance amplifier 410 and the output terminal of the second-stage operational transconductance amplifier 420. In the embodiments of the present disclosure, the frequency correction method 300 may include following steps S310-S320.

At the step S310, charging and discharging are performed on the compensation capacitor by an output current from the first-stage operational transconductance amplifier to output a clock signal.

In the present embodiment, a bias voltage can be provided to the first-stage operational transconductance amplifier, and charging and discharging can be performed on the compensation capacitor by the output current from the first-stage operational transconductance amplifier, thereby obtaining a clock signal. Specifically, as shown in FIG. 8, the step S310 may be implemented by steps S311-S313.

At the step S311, the capacitance matching device and the compensation capacitor are configured as a capacitor array.

In the present embodiment, an additional capacitance matching device and the compensation capacitor may be configured as a capacitor array. The capacitance matching device may include a plurality of capacitors, and the capacitance of the capacitance matching device may be adjusted by appropriately configuring the plurality of capacitors in the capacitance matching device. Since the capacitance matching device and the compensation capacitor together form the capacitor array, when the capacitance of the capacitance matching device is adjusted, the capacitance of the capacitor array is correspondingly changed, which is also equivalent to adjusting the capacitance of the compensation capacitor. It can be seen that the additional capacitance matching device and the compensation capacitor are configured as the capacitor array, and when the capacitance of the capacitance matching device is adjusted, which is equivalent to adjusting the capacitance of the compensation capacitor, so that the capacitance of the compensation capacitor can be adjusted.

At the step S312, the voltage across the capacitor array is compared with a threshold voltage to output a comparison signal.

In the present embodiment, the threshold voltage may include a first threshold voltage and a second threshold voltage. Specifically, when the capacitor array is in a charging state, the voltage across the capacitor array is compared with the first threshold voltage during increasing of the voltage across the capacitor array to generate a first comparison signal; and when the capacitor array is in a discharging state, the voltage across the capacitor array is compared with the second threshold voltage during decreasing of the voltage across the capacitor array to generate a second comparison signal.

At the step S313, charging and discharging of the capacitor array are controlled according to the comparison signal, to output a clock signal.

In the present embodiment, when the capacitor array generates the first comparison signal in the charging state, the capacitor array can be controlled to be transformed from the charging state to the discharging state; and when the capacitor array generates the second comparison signal in the discharging state, the capacitor array can be controlled to be transformed from the discharging state to the charging state. Thus, a periodic clock signal is generated through repeated oscillations described above.

As one implementation, when the capacitor array generates the first comparison signal in the charging state, that is, when the capacitor array is transformed from the charging state to the discharging state, the threshold voltage may be configured from the first threshold voltage to the second threshold voltage; and when the capacitor array generates the second comparison signal in the charging state, that is, when the capacitor array is transformed from the discharging state to the charging state, the threshold voltage may be configured from the second threshold voltage to the first threshold voltage.

At the step S320, the capacitance of the compensation capacitor is adjusted to enable the clock frequency of the clock signal to be consistent with the preset clock frequency.

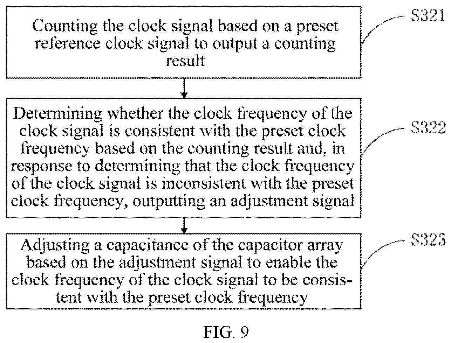

In the present embodiment, the capacitance of the compensation capacitor is adjusted, that is, the capacitance of the capacitance matching device is adjusted, so that the clock frequency of the clock signal is consistent with the preset clock frequency by adjusting the capacitance of the compensation capacitor, and the influence on the clock signal due to the process variation can be eliminated. Specifically, as shown in FIG. 9, the step S320 may be implemented by steps S321-S323.

At the step S321, the clock signal is counted according to the preset reference clock signal to output a counting result.

In the present embodiment, the frequency of the preset reference clock signal is greater than that of the clock signal. Alternatively, the clock signal may be counted with the preset reference clock signal as the high frequency reference clock to obtain a counting result.

At the step S322, whether the clock frequency of the clock signal is consistent with the preset clock frequency is determined according to the counting result, and if it is determined that the clock frequency of the clock signal is inconsistent with the preset clock frequency, then an adjustment signal is outputted.

In the present embodiment, it may be specified that a counting result corresponding to the preset clock frequency is the preset counting result. If the counting result of the clock signal is inconsistent with the preset counting result, it is illustrated that the clock frequency of the clock signal is inconsistent with the predetermined clock frequency, and in this case, an adjustment signal may be outputted.

At the step S323, the capacitance of the capacitor array is adjusted according to the adjustment signal to enable the clock frequency of the clock signal to be consistent with the preset clock frequency.

In the present embodiment, the capacitance of the capacitance matching device can be adjusted according to the adjustment signal to adjust the capacitance of the capacitor array, which is also equivalent to adjusting the capacitance of the compensation capacitor.

Specifically, by adjusting the capacitance of the capacitor array, an oscillation period of the clock signal can be changed, thereby changing the clock frequency of the clock signal. In the present embodiment, the capacitance of the capacitor array is adjusted, until the counting result of the clock signal is consistent with the specified preset counting result corresponding to the preset clock frequency, that is, the clock frequency of the clock signal is consistent with the preset clock frequency. By adjusting the clock frequency of the clock signal to be consistent with the preset clock frequency, the clock signal is kept stable, thereby eliminating the influence on the clock frequency of the clock signal due to the capacitor process variation and ensuring that the programmable gain amplifier maintains a constant bandwidth without being affected by the capacitor process.

According to the frequency correction method according to some embodiments of the present disclosure, charging and discharging are performed on the compensation capacitor by the output current from the first-stage operational transconductance amplifier to output the clock signal, and the capacitance of the compensation capacitor is adjusted to enable the clock frequency of the clock signal to be consistent with the preset clock frequency, so that the programmable gain amplifier ensures a constant bandwidth without being affected by the process.

The above only shows the preferred embodiment of the present disclosure, and does not make any formal limitation on the present disclosure. Although the present disclosure has been disclosed as above in the preferred embodiments, it is not intended to limit the present disclosure. Any person skilled in the art may make a few changes or modifications to equivalent embodiments without departing from the technical solution of the present disclosure, but it is within the scope of the technical solution of the present application to make any introductory modifications, equivalent changes and modifications to the above embodiments in accordance with the technical substance of the present disclosure without departing from the technical solution of the present disclosure.

## Claims

1. A programmable gain amplifier, comprising:

   a first-stage operational transconductance amplifier;
   a second-stage operational transconductance amplifier having an input terminal connected to an output terminal of the first-stage operational transconductance amplifier;

a capacitor module connected between the output terminal of the first-stage operational transconductance amplifier and an output terminal of the second-stage operational transconductance amplifier;

a clock oscillation circuit connected to both the output terminal of the first-stage operational transconductance amplifier and the capacitor module, and configured to perform charging and discharging of the capacitor module by an output current from the first-stage operational transconductance amplifier to output a clock signal; and

a correction circuit connected to both the clock oscillation circuit and the capacitor module, and configured to adjust a capacitance of the capacitor module to enable a clock frequency of the clock signal to be consistent with a preset clock frequency.

2. The programmable gain amplifier of claim 1, wherein the clock oscillation circuit comprises:

a comparator connected to the capacitor module and configured to compare a voltage across the capacitor module with a preset threshold voltage to output a comparison signal;

a charging/discharging switch connected in parallel with the capacitor module; and

a logic control circuit connected to both the comparator and the charging/discharging switch, and configured to control the charging/discharging switch to be turned on or off based on the comparison signal, to perform charging and discharging of the capacitor module to output the clock signal.

3. The programmable gain amplifier of claim 2, wherein the preset threshold voltage is one of a first threshold voltage and a second threshold voltage;

the comparator is configured to compare the voltage across the capacitor module with the one of the first threshold voltage and the second threshold voltage to output corresponding one of comparison signals;

the logic control circuit is configured to output, based on the voltage across the capacitor module being increased to the first threshold voltage, a first control signal to control the charging/discharging switch to be turned on to perform discharging of the capacitor module, or output, based on the voltage across the capacitor module being decreased to the second threshold voltage, a second control signal to control the charging/discharging switch to be turned off to perform charging of the capacitor module; and

the clock oscillation circuit further comprises a threshold selection circuit for configuring the threshold voltage as the second threshold voltage based on the first control signal and configuring the threshold voltage as the first threshold voltage based on the second control signal.

4. The programmable gain amplifier of claim 2, wherein the correction circuit comprises:

a counter connected to the logic control circuit and configured to count the clock signal based on a preset reference clock signal to output a counting result, wherein a frequency of the preset reference clock signal is greater than a frequency of the clock signal;

a quantizer connected to the counter and configured to determine, based on the counting result, whether the clock frequency of the clock signal is consistent with the preset clock frequency and, in response to determining that the clock frequency of the clock signal is inconsistent with the preset clock frequency, output an adjustment signal; and

an adjustment circuit connected to both the quantizer and the capacitor module and configured to adjust the capacitance of the capacitor module based on the adjustment signal to enable the clock frequency of the clock signal to be consistent with the preset clock frequency.

5. The programmable gain amplifier of claim 1, wherein the capacitor module comprises:

a compensation capacitor connected between the output terminal of the first-stage operational transconductance amplifier and the output terminal of the second-stage operational transconductance amplifier; and

a capacitance matching device connected in parallel with the compensation capacitor; and wherein the correction circuit is connected to the capacitance matching device and configured to adjust a capacitance of the capacitance matching device to adjust the capacitance of the capacitor module.

6. The programmable gain amplifier of any one of claims 1 to 5, further comprising:
a mode switching circuit for switching the programmable gain amplifier between a correction mode and an operation mode.

7. The programmable gain amplifier of claim 6, wherein the mode switching circuit comprises:

a first switch connected between the capacitor module and the output terminal of the second-stage operational transconductance amplifier; and

a second switch having one terminal grounded and another terminal connected between the capacitor module and the first switch, wherein the mode switching circuit is configured to switch the programmable gain amplifier to the operation mode by turning on the first switch and turning off the second switch, or switch the programmable gain amplifier to the correction mode by turning off the first switch and turning on the second switch.

8. The programmable gain amplifier of any one of claims 1 to 5, further comprising:
a buffer circuit connected to the output terminal of the second-stage operational transconductance amplifier.

9. An integrated circuit, comprising the programmable gain amplifier of any one of claims 1 to 8.

10. An electronic device, comprising:

a device body; and
the integrated circuit of claim 9, disposed within the device body.

11. A frequency correction method for a programmable gain amplifier applied to the programmable gain amplifier, wherein the programmable gain amplifier comprises: a first-stage operational transconductance amplifier; a second-stage operational transconductance amplifier having an input terminal connected to an output terminal of the first-stage operational transconductance amplifier; and a compensation capacitor connected between the output terminal of the first-stage operational transconductance amplifier and an output terminal of the second-stage operational transconductance amplifier, and the method comprises:

performing charging and discharging of the compensation capacitor by an output current from the first-stage operational transconductance amplifier to output a clock signal; and
adjusting a capacitance of the compensation capacitor to enable a clock frequency of the clock signal to be consistent with a preset clock frequency.

12. The method of claim 11, wherein the performing of charging and discharging of the compensation capacitor to output the clock signal comprises:

configuring a capacitance matching device and the compensation capacitor as a capacitor array;

comparing a voltage across the capacitor array with a threshold voltage to output a comparison signal; and
controlling charging and discharging of the capacitor array based on the comparison signal to output the clock signal.

13. The method of claim 12, wherein the adjusting of the capacitance of the compensation capacitor comprises:

counting the clock signal based on a preset reference clock signal to output a counting result;
determining whether the clock frequency of the clock signal is consistent with the preset clock frequency based on the counting result, and in response to determining that the clock frequency of the clock signal is inconsistent with the preset clock frequency, outputting an adjustment signal; and
adjusting a capacitance of the capacitor array based on the adjustment signal to enable the clock frequency of the clock signal to be consistent with the preset clock frequency;
wherein a frequency of the preset reference clock signal is greater than a frequency of the clock signal.

100

130~ 

Capacitor
module

110

First-stage opera-
tional transcon-
ductance amplifier

120

Second-stage op-
erational
transconductance
amplifier

140

Clock oscillation
circuit

150

Correction
circuit

140

FIG. 1

100

132 — Capacitance matching device
130
131 — Compensation capacitor
172 — Second switch
170
150
Adjustment circuit — 153

142 — Charging/-discharging switch
First switch
Quantizer — 152
160

171

110
First-stage operational transconductance amplifier
120 — Second-stage operational transconductance amplifier
Buffer circuit

141

Threshold selection circuit
Comparator
Logic control circuit — 143
Counter — 151

144
140

FIG. 2

100

132
130
131
142

Adjust-ment circuit — 153

Q2
170

Quantizer — 152

Q6
Q1

Vin — Q5
110
OTA
120
Gm
160
buffer

Vbias — Q4

Counter — 151

Q3
VH
VL
Threshold selection circuit
141
COMP
Logic control circuit — 143

144

FIG. 3

FIG. 4

FIG. 5

300

| Performing charging and discharging of the compensation capacitor by an output current from the first-stage operational transconductance amplifier to output a clock signal | S310 |

↓

| Adjusting a capacitance of the compensation capacitor to enable a clock frequency of the clock signal to be consistent with a preset clock frequency | S320 |

FIG. 6

400                                                      430

Second-stage operational transconductance amplifier

First-stage operational transconductance amplifier

Compensation capacitor

410                                                      420

FIG. 7

| Configuring a capacitance matching device and the compensation capacitor as a capacitor array | S311 |

↓

| Comparing a voltage across the capacitor array with a threshold voltage to output a comparison signal | S312 |

↓

| Controlling charging and discharging of the capacitor array based on the comparison signal to output the clock signal | S313 |

FIG. 8

Counting the clock signal based on a preset
reference clock signal to output a counting
result

S321

Determining whether the clock frequency of the
clock signal is consistent with the preset clock
frequency based on the counting result and, in
response to determining that the clock frequency
of the clock signal is inconsistent with the preset
clock frequency, outputting an adjustment signal

S322

Adjusting a capacitance of the capacitor array
based on the adjustment signal to enable the
clock frequency of the clock signal to be consistent with the preset clock frequency

S323

FIG. 9

## INTERNATIONAL SEARCH REPORT

| International application No. |
|---|
| **PCT/CN2022/104425** |

### A. CLASSIFICATION OF SUBJECT MATTER

H03G 3/30(2006.01)i

According to International Patent Classification (IPC) or to both national classification and IPC

### B. FIELDS SEARCHED

Minimum documentation searched (classification system followed by classification symbols)

H03G

Documentation searched other than minimum documentation to the extent that such documents are included in the fields searched

Electronic data base consulted during the international search (name of data base and, where practicable, search terms used)

CNABS; CNTXT; DWPI; VEN; ENTXT; USTXT; WOTXT; EPTXT; CNKI; IEEE: 放大器, 增益, 电容器, 时钟, 振荡器, 调整, 频率; amplifier, gain, capacitor, clock, oscillator, adjust, frequency

### C. DOCUMENTS CONSIDERED TO BE RELEVANT

| Category* | Citation of document, with indication, where appropriate, of the relevant passages | Relevant to claim No. |
|---|---|---|
| PX | CN 113258896 A (SHENZHEN CHIPSEA TECHNOLOGIES CO., LTD.) 13 August 2021 (2021-08-13)<br>description, paragraphs 4-87, and figures 1-9 | 1-13 |
| Y | CN 111293879 A (NANJING YUANFENG MICROELECTRONICS CO., LTD.) 16 June 2020 (2020-06-16)<br>description, paragraphs 6-31, and figure 3 | 1-2, 6-11 |
| A | CN 111293879 A (NANJING YUANFENG MICROELECTRONICS CO., LTD.) 16 June 2020 (2020-06-16)<br>description, paragraphs 6-31, and figure 3 | 3-5, 12-13 |
| Y | CN 112019177 A (MEDIATEK INC.) 01 December 2020 (2020-12-01)<br>description, paragraphs 21-36, and figures 7-8 | 1-2, 6-11 |
| A | CN 112019177 A (MEDIATEK INC.) 01 December 2020 (2020-12-01)<br>description, paragraphs 21-36, and figures 7-8 | 3-5, 12-13 |
| A | CN 106788338 A (HANGZHOU SILAN MICROELECTRONICS CO., LTD.) 31 May 2017 (2017-05-31)<br>description, paragraphs 11-116, and figures 1-8 | 1-13 |

☑ Further documents are listed in the continuation of Box C. ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **23 August 2022** | **08 September 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
|---|
| **PCT/CN2022/104425** |

**C.    DOCUMENTS CONSIDERED TO BE RELEVANT**

| Category* | Citation of document, with indication, where appropriate, of the relevant passages | Relevant to claim No. |
|---|---|---|
| A | US 2008068107 A1 (LUICH, T. M.) 20 March 2008 (2008-03-20) description, paragraphs 35-57, and figures 1-12 | 1-13 |

Form PCT/ISA/210 (second sheet) (January 2015)

**INTERNATIONAL SEARCH REPORT**
Information on patent family members

| International application No. |
| --- |
| **PCT/CN2022/104425** |

| Patent document cited in search report | | | Publication date (day/month/year) | Patent family member(s) | | | Publication date (day/month/year) |
| --- | --- | --- | --- | --- | --- | --- | --- |
| CN | 113258896 | A | 13 August 2021 | CN | 113258896 | B | 01 October 2021 |
| CN | 111293879 | A | 16 June 2020 | CN | 212086064 | U | 04 December 2020 |
| CN | 112019177 | A | 01 December 2020 | EP | 3745590 | A1 | 02 December 2020 |
| | | | | US | 2020382072 | A1 | 03 December 2020 |
| | | | | TW | 202046635 | A | 16 December 2020 |
| | | | | TW | 730783 | B1 | 11 June 2021 |
| | | | | US | 11196387 | B2 | 07 December 2021 |
| CN | 106788338 | A | 31 May 2017 | None | | | |
| US | 2008068107 | A1 | 20 March 2008 | None | | | |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202110773516X